# EUROPEAN PATENT APPLICATION

(11) **EP 4 825 827 A1**
(43) Date of publication of application: **21.10.2026**
(21) Application number: 24903219.4
(22) Date of filing: 02.08.2024
(51) Int. Cl.: C04B 35/495, H10N 30/20, H10N 30/30, H10N 30/074, H10N 30/853

(54) **LEAD-FREE PIEZOELECTRIC COMPOSITION, PIEZOELECTRIC ELEMENT, AND DEVICE**

(30) Priority: 11.12.2023 JP 2023208681
(71) Applicant: Niterra Co., Ltd., Nagoya-shi, Aichi 461-0005 (JP)
(72) Inventor: HIROSE, Yoshinobu, Nagoya-shi, Aichi 461-0005 (JP); MARUYAMA, Koji, Nagoya-shi, Aichi 461-0005 (JP); ICHIHASHI, Kentaro, Nagoya-shi, Aichi 461-0005 (JP); KASASHIMA, Takashi, Nagoya-shi, Aichi 461-0005 (JP); YAMAZAKI, Masato, Nagoya-shi, Aichi 461-0005 (JP)
(74) Representative: J A Kemp LLP
(86) International application number: PCT/JP2024/027794
(87) International publication number: WO 2025/126556

(57) **Abstract**

A lead-free piezoelectric composition includes a primary phase formed of an alkali niobate-based perovskite-type oxide, and a secondary phase containing a metal oxide which differs from the alkali niobate-based perovskite-type oxide forming the primary phase. The composition has a Young's modulus of 90 GPa or higher.

## Description

### TECHNICAL FIELD

The present disclosure relates to a lead-free piezoelectric composition, to a piezoelectric element, and to a device.

### BACKGROUND ART

Hitherto, PZT-based (lead zirconate titanate-based) compositions which exhibit piezoelectricity have been widely used. However, for reducing and environmental load and for other reasons, there is demand for the development of a lead-free piezoelectric composition which contains no lead. As a candidate of such a lead-free piezoelectric composition, there has been proposed, for example, an alkali niobate-based perovskite oxide. Specifically, Patent Literatures 1 and 2 disclose a technical feature that the composition of a piezoelectric material containing, as a main component, a compound represented by KₓNa₍₁₋ₓ₎NbO₃ (i.e., a KNN-type piezoelectric material) is regulated to a specific value, to thereby enhance piezoelectric characteristics including mechanical quality factor Qm. The mechanical quality factor Qm is a parameter which shows the sharpness (in resonance spectrum) of mechanical vibration at a resonance frequency or thereabouts when a piezoelectric composition undergoes characteristic vibration. The higher the mechanical quality factor Qm, the lower the loss. Thus, the efficiency of an actuator including a piezoelectric composition can be enhanced through the above technical feature.

### CITATION LIST

### PATENT LITERATURE

Patent Literature 1: JP6326198B
Patent Literature 2: JP4929522B

### SUMMARY OF INVENTION

### TECHNICAL PROBLEM

Such a lead-free piezoelectric composition is required to have further enhanced piezoelectric characteristics. Regarding mechanical quality factor Qm, the percent change in Qm within a range of low load to high load (i.e., low vibration stress to high vibration stress) is preferably smaller. More specifically, since Qm generally decreases with an increase in load, a drop in Qm is preferably minimized under an increase in load, particularly in uses which must be operated under high load. However, no sufficient elucidation has been given for a technical feature of suppressing change in mechanical quality factor Qm of an alkali niobate-based perovskite oxide within a range of low load to high load.

### SOLUTION TO PROBLEM

The present disclosure may be carried out as the following aspects.
[1] In one aspect of the present disclosure, a lead-free piezoelectric composition is provided. The lead-free piezoelectric composition includes a primary phase formed of an alkali niobate-based perovskite-type oxide, and a secondary phase containing a metal oxide which differs from the alkali niobate-based perovskite-type oxide forming the primary phase. The composition has a Young's modulus of 90 GPa or higher.
   According to the lead-free piezoelectric composition according to the above aspect, the Young's modulus of the lead-free piezoelectric composition is adjusted to 90 GPa or higher, the composition including a primary phase formed of an alkali niobate-based perovskite-type oxide, and a secondary phase containing a metal oxide which differs from the alkali niobate-based perovskite-type oxide forming the primary phase. As a result, the percent change in mechanical quality factor Qm within a range of low load to high load (i.e., low vibration stress to high vibration stress) can be suppressed. Thus, a piezoelectric element exhibiting stable piezoelectric characteristics within a range of low load to high load can be yielded.
[2] In the lead-free piezoelectric composition according to the above aspect, the Young's modulus may be adjusted to 100 GPa or higher. According to the technical feature, the effect of suppressing the change in mechanical quality factor Qm can be further enhanced.
[3] In the lead-free piezoelectric composition according to the above aspect, the Young's modulus may be adjusted to 105 GPa or higher. According to the technical feature, the effect of suppressing the change in mechanical quality factor Qm can be further enhanced.
[4] In the lead-free piezoelectric composition according to the above aspect, the metal oxide forming the secondary phase may include at least one of a metal oxide having a spinel-type structure and a metal oxide having a tungsten bronze-type structure. According to the technical feature, sinterability of the lead-free piezoelectric composition can be enhanced.
[5] In the lead-free piezoelectric composition according to the above aspect, the alkali niobate-based perovskite-type oxide forming the primary phase may be formed of an alkali niobate-based perovskite-type oxide represented by a compositional formula (A1ₐM1_{b})_{c}(Nb_{d1}M2_{d2}M3_{d3})O₃₊ₑ (in which element A1 represents at least one alkali metal; element M1 represents at least one of Ba, Ca, and Sr; element M2 represents at least one of Ti, Zr, Ta, Hf, Sn, Sb, and Si; element M3 represents at least one of Mn, Mg, Al, Sc, Fe, Co, Ni, Zn, Ga, and Y; condition: a+b=1 is satisfied; c satisfies a condition: 0.80<c<1.10; conditions: 0<d1<1 and d1+d2+d3=1 are satisfied; and e is a value showing oxygen deficiency or excess). According to the technical feature, the mechanical quality factor Qm of the lead-free piezoelectric composition can be further enhanced.
[6] In the lead-free piezoelectric composition according to the above aspect, the element A1 may be at least one of K and Na; the element M2 may be at least one of Ti and Zr; the element M3 may be Mn; and the condition 0<a≤1 may be satisfied. According to the technical feature, the piezoelectric characteristics of the lead-free piezoelectric composition can be easily enhanced.
[7] In another aspect of the present disclosure, there is provided a piezoelectric element having a piezoelectric body formed of a lead-free piezoelectric composition as recited in any one of [1] to [6] above, and an electrode attached to the piezoelectric body.
   According to the piezoelectric element of the aspect, the piezoelectric characteristics of the piezoelectric composition can be stabilized under low load to high load. As a result, energy loss in driving under high load can be reduced, to thereby realize consistent driving.
[8] In still another aspect of the present disclosure, there is provided a device having a piezoelectric element as recited in [7] above.
   The device of the aspect has a piezoelectric element containing a lead-free piezoelectric composition which achieves stable piezoelectric characteristics within a range of low load to high load. As a result, the general performance of the device can be enhanced.

The present disclosure can be carried out as a variety of embodiments, for example, a lead-free piezoelectric composition, a piezoelectric element employing the composition, various devices employing the piezoelectric element (e.g., an ultrasonic surgical knife, an ultrasonic scaler, an ultrasonic cleaning machine, an ultrasonic processing machine, a piezoelectric transducer, an ultrasonic motor, a piezoelectric gyro sensor, a piezoelectric filter, and a knock sensor), a method manufacturing a lead-free piezoelectric composition, etc.

### BRIEF DESCRIPTION OF DRAWINGS

[FIG. 1] Perspective view of an appearance of a piezoelectric element.
[FIG. 2] Flowchart showing an example of a piezoelectric element manufacturing method.
[FIG. 3] Schematic view of an ultrasonic surgical knife as an example of the device.
[FIG. 4] Schematic view of an ultrasonic scaler as an example of the device.
[FIG. 5] Schematic view of an ultrasonic cleaning machine as an example of the device.
[FIG. 6] Schematic view of an ultrasonic processing machine as an example of the device.
[FIG. 7] Schematic view of a piezoelectric transducer as an example of the device.
[FIG. 8] Schematic view of an ultrasonic motor as an example of the device.
[FIG. 9] Schematic view of a piezoelectric gyro sensor as an example of the device.
[FIG. 10] Schematic view of a stacked piezoelectric filter as an example of the device.
[FIG. 11] Schematic view of a knock sensor as an example of the device.
[FIG. 12] A table (i.e., a schematic drawing) collectively showing features of samples and results of evaluation.
[FIG. 13] A table showing primary phase features of samples.

### DESCRIPTION OF EMBODIMENTS

### A. Lead-free piezoelectric composition

The lead-free piezoelectric composition of an embodiment includes a primary phase formed of an alkali niobate-based perovskite-type oxide, and a secondary phase containing a metal oxide which differs from the alkali niobate-based perovskite-type oxide forming the primary phase. The composition has a Young's modulus of 90 GPa or higher.

### (A-1) Primary phase:

The alkali niobate-based perovskite oxide forming the primary phase preferably contains, as an alkaline component, at least one species among alkali metals (e.g., potassium (K), sodium (Na), and lithium (Li)), particularly preferably at least one of potassium (K) and sodium (Na). Also, the alkali niobate-based perovskite oxide forming the primary phase may contain, as an alkaline component, an alkaline earth metal (i.e., at least one species of calcium (Ca), strontium (Sr), barium (Ba), etc.).

The alkali niobate-based perovskite-type oxide forming the primary phase may further contain manganese (Mn). Conceivably, when manganese (Mn) serving as an acceptor forms a solid solution at niobium sites (i.e., B site of a perovskite-type crystal structure), mechanical quality factor Qm can be enhanced. However, manganese (Mn) is not an essential component.

In addition, the alkali niobate-based perovskite oxide forming the primary phase is preferably an alkali niobate-based perovskite-type oxide satisfying the following compositional formula (1).

(A1ₐM1_{b})_{c}(Nb_{d1}M2_{d2}M3_{d3})O₃₊ₑ ··· (1)

In the formula, element A1 represents at least one alkali metal; element M1 represents at least one of Ba, Ca, and Sr; element M2 represents at least one of Ti, Zr, Ta, Hf, Sn, Sb, and Si; element M3 represents at least one of Mn, Mg, Al, Sc, Fe, Co, Ni, Zn, Ga, and Y; condition: a+b=1 is satisfied; c satisfies a condition: 0.80<c<1.10; conditions: 0<d1<1 and d1+d2+d3=1 are satisfied; and e is a value showing oxygen deficiency or excess,.

In the aforementioned compositional formula (1), element A1 and element M1 are present in the A site of the perovskite structure, and Nb, element M2, and element M3 are present in the B site. In the compositional formula (1), coefficients a, b, d1 to d3, and e are selected from the aforementioned values which are preferred from the viewpoints of electrical characteristics and piezoelectric characteristics of the lead-free piezoelectric composition, so long as the combination of coefficients ensures establishment of the perovskite structure. In the alkali niobate-based perovskite oxide represented by compositional formula (1), the case of d1=0 (i.e., the composition containing no Nb) is excluded. The alkali niobate-based perovskite oxide represented by compositional formula (1) contains at least one of element M2 and element M3.

In coefficient (3+e) with respect to oxygen, the value of e is a positive or negative value showing deviation (deficiency or excess) from the intrinsic value of 3 with respect to oxygen. Coefficient (3+e) with respect to oxygen may be a value which allows the primary phase to have a perovskite oxide structure. Typically, coefficient e is 0, and preferably satisfies - 0.1≤e≤0.1. Notably, coefficient e may also be calculated from the composition of the primary phase to meet the electrically neutral condition. However, needless to say, a composition of the primary phase which is slightly deviated from the electrically neutral condition is also allowable.

In the above compositional formula (1), the element A1 may be at least one of K and Na; the element M2 may be at least one of Ti and Zr; the element M3 may be Mn; and the condition 0<a≤1 may be satisfied. According to the technical feature, the piezoelectric characteristics of the lead-free piezoelectric composition can be easily enhanced. Such a alkali niobate-based perovskite-type oxide may be represented by the following compositional formula (2).

((Kₐ₁Naₐ₂)(Ba_{b1}Ca_{b2}Sr_{b3}))_{c}(Nb_{d1}(Ti_{d2x}Zr_{d2y})Mn_{d3})O₃₊ₑ ··· (2)

In the formula, conditions: a1+a2=a, b1+b2+b3=b, and d2x+d2y=d2, and a+b=1 are satisfied; condition c: 0.80<c<1.10 is satisfied; conditions: 0<d1<1 and d1+d2+d3=1 are satisfied; and e is a value showing oxygen deficiency or excess). The e preferably satisfies the condition: -0.1≤e≤0.1.

In this case, particularly preferably, element A1 satisfies conditions: 0<a1<1 and 0<a2<1; element M1 satisfies the conditions: 0≤b1≤0.2, 0≤b2≤0.2, 0≤b3≤0.2; element M2 satisfies the conditions: 0≤d2x≤0.2 and 0≤d2y≤0.2; and Mn satisfies the condition: 0≤d3≤0.1. As a result, the piezoelectric characteristics of the lead-free piezoelectric composition can be further enhanced. Also, more preferably, element A1 satisfies conditions: 0<a1≤0.7 and 0.3≤a2<1; element M1 satisfies the conditions: 0≤b1≤0.1, 0≤b2≤0.1, 0≤b3≤0.1; element M2 satisfies the conditions: 0≤d2x≤0.1 and 0≤d2y≤0.1; and Mn satisfies the condition: 0≤d3≤0.08. As a result, the piezoelectric characteristics of the lead-free piezoelectric composition can be yet further enhanced.

### (A-2) Secondary phase:

The metal oxide forming the secondary phase is a metal oxide differing from the alkali niobate-based perovskite-type oxide forming the primary phase. By virtue of the presence of the secondary phase, sinterability of the lead-free piezoelectric composition, among others, may be enhanced. In addition, by virtue of co-presence of the secondary phase and the primary phase, the crystal structure of the primary phase can be stabilized, leading to enhancement in piezoelectric characteristics. Also, the secondary phase can suppress occurrence of a steep change in characteristics, which would otherwise be caused by the presence of a phase transition point between -50°C and +150°C in the lead-free piezoelectric composition. The secondary phase may include, as a metal oxide differing from the alkali niobate-based perovskite-type oxide, one metal oxide or a plurality of metal oxides. Further, the secondary phase may include a crystalline phase differing from that of the aforementioned metal oxide, and may contain an impurity element.

The metal oxide forming the secondary phase having the above properties may be formed from, for example, at least one of a metal oxide having a spinel-type structure and a metal oxide having a tungsten bronze-type structure. Also, the metal oxide forming the secondary phase may be formed from, in addition to or instead of the aforementioned metal oxide(s), at least one of an A₂B₆O₁₃-type compound (in which element A represents a monovalent metal, and element B represents a 2- to 6-valent metal) and an A-Ti-B-O-type compound (in which element A represents an alkali metal, and element B represents at least one of Nb and Ta).

In the present specification the "metal oxide having a spinel-type structure" encompasses both a normal spinel compound having a normal spinel-type structure and an inverse spinel compound having an inverse spinel-type structure. The metal oxide having a spinel-type structure may be, for example, an M-Ti-O-type spinel compound, and is preferably a compound represented by the following formula (3).

MₓTiO_{y} ··· (3)

In the above formula (3), element M represents a 1- to 4-valent metal element; at least one of lithium (Li), magnesium (Mg), aluminum (Al), scandium (Sc), chromium (Cr), manganese (Mn), iron (Fe), cobalt (Co), nickel (Ni), zinc (Zn), gallium (Ga), yttrium (Y), zirconium (Zr), tin (Sn), antimony (Sb), silicon (Si), and hafnium (Hf). Notably, in the case in which element M includes Li, one or more additional metal elements among the above metal elements other than Li are preferably incorporated with Li, in order to provide the compound represented by formula (3) with a spinel-type crystal structure. Coefficients x and y are relative values with respect to Ti content as 1. When the compound represented by formula (3) forms a spinel compound, coefficient x preferably satisfies the condition: 0.5≤x≤5.0. Coefficient y is such a value as to form a spinel compound and is typically satisfies the following preferred conditions: 2≤y≤8. So long as the spinel-type crystal structure can be maintained, and variations in characteristics of the compound fall within an allowable range, the values of coefficients x and y may be deviated from the above typical values. From the viewpoint of piezoelectric characteristics, the compound represented by formula (3) is preferably a compound represented by a compositional formula M₂TiO₄ including two divalent metal elements M, or a compound represented by a compositional formula (M1,M2)TiO₄ including two metal elements M.

The compound having a tungsten bronze-type structure is a compound represented by the following formula (4).

AₕBᵢO_{15+δ} ··· (4)

In the above formula (4), element A includes two or more monovalent or divalent elements, and element B includes one or more 2- to 5-valent elements. The element A is preferably at least one element among sodium (Na), potassium (K), lithium (Li), barium (Ba), calcium (Ca), and strontium (Sr). The element B is preferably at least one element among niobium (Nb), manganese (Mn), iron (Fe), nickel (Ni), cobalt (Co), zinc (Zr), and zirconium (Zr). Coefficients h, i, and δ are 3, 5, and 0, respectively as standard values. However, these values may be deviated from the above standard values, so long as the tungsten bronze-type crystal structure can be maintained, and variations in characteristics of the compound fall within an allowable range. The element B may contain an impurity element. The element B of the compound represented by the above formula (4) is preferably Nb, and specific examples include Ba₂KNb₅O₁₅, Ba₂NaNb₅O₁₅, Ca₂KNbsO₁₅, and Ca₂NaNb₅O₁₅.

As the A₂B₆O₁₃-type compound, there may be employed a compound in which the element A (monovalent metal) is at least one of Li, Na, and K and the element B (2- to 6-valent metal) is at least on of Co, Fe, Mg, Ni, Zr, Mn, Al, Nb, Ta, and W. More specifically, K₂(Ti,Nb,Mg)₆O₁₃, K₂(Ti,Nb,Co,Zn)₆O₁₃, and the like may be employed.

As the A-Ti-B-O-type compound, a compound having a composition represented by the following formula (5) or (6) may be employed.

A₁₋ₓTi₁₋ₓB₁₊ₓO₅ ··· (5)

A₁Ti₃B₁O₉ ··· (6)

In the formulas, element A is at least one of alkali metals (e.g., potassium (K), rubidium (Rb), and cesium (Cs)), and element B is at least one of niobium (Nb) and tantalum (Ta). Although coefficient x in the above formula (5) may be any value, the coefficient x preferably satisfies the condition 0≤x≤0.15. When the coefficient x falls within the range, the structure of the compound can be stabilized, to thereby yield a uniform crystalline phase.

Generally, metal oxides for forming the aforementioned secondary phase, such as an oxide having a spinel-type structure and a compound having a tungsten bronze-type structure, have no piezoelectric characteristics. However, when any of such metal oxides is co-present with the primary phase formed of an alkali niobate-based perovskite oxide, sinterability of the piezoelectric composition can be enhanced. From the viewpoint of securing the effect of enhancing the sinterability of the lead-free piezoelectric composition, the secondary phase content is preferably adjusted to 0.3 vol% or more, more preferably 0.5 vol% or more. Also, from the viewpoint of securing the piezoelectric characteristics of the lead-free piezoelectric composition, the secondary phase content is preferably adjusted to 10 vol% or less, more preferably 7 vol% or less. Notably, information about the species of the compound forming the secondary phase; e.g., whether the secondary phase is formed of a metal oxide having a spinel-type structure, or a metal oxide having a tungsten bronze-type structure, may be determined through Rietveld analysis employing the results of powder X-ray diffractometry (XRD).

### (A-3) Young's modulus:

As described above, the lead-free piezoelectric composition of the present embodiment has a Young's modulus of 90 GPa or higher. By adjusting the Young's modulus to fall within the above range, the percent change in mechanical quality factor Qm within a range of low load to high load (i.e., low vibration stress to high vibration stress) can be suppressed in the lead-free piezoelectric composition. The percent change in mechanical quality factor Qm within a range of low load to high load can be evaluated under, for example, the following conditions. Specifically, a vibration stress Tm of 1 MPa is defined as a low load, and that of 20 MPa is defined as a high load. The percent change is calculated from a Qm value at a Tm of 1 MPa and that at a Tm of 20 MPa. One conceivable reason for successfully suppressing the percent change in mechanical quality factor Qm is as follows. By tuning the Young's modulus to fall within the above range, hardness of the lead-free piezoelectric composition is secured, whereby the structure of the ceramic material forming the lead-free piezoelectric composition (more specifically, a domain structure in a particle or the like) is stabilized. From the viewpoint of enhancing the Young's modulus of the lead-free piezoelectric composition so as to attain the aforementioned effect by securing the hardness of the lead-free piezoelectric composition, the Young's modulus of the lead-free piezoelectric composition is preferably 100 GPa or higher, more preferably 105 GPa or higher, still more preferably 120 GPa or higher.

In contrast, when the Young's modulus of the lead-free piezoelectric composition increases to provide the lead-free piezoelectric composition with excessively high hardness, difficulty is encountered in vibration of the lead-free piezoelectric composition. In such case, piezoelectric performance of a piezoelectric element including the lead-free piezoelectric composition may be impaired. Thus, from the viewpoint of suppressing a drop in the aforementioned piezoelectric performance, the Young's modulus of the lead-free piezoelectric composition is preferably, for example, 150 GPa or lower, more preferably 140 GPa or lower, still more preferably 130 GPa or lower.

The Young's modulus of the lead-free piezoelectric composition may be regulated on the basis of, for example, the composition of the primary phase or the secondary phase forming the lead-free piezoelectric composition, particularly, the composition of the primary phase, which corresponds to a higher content in the lead-free piezoelectric composition. Also, the Young's modulus of the lead-free piezoelectric composition may be regulated on the basis of conditions under which the lead-free piezoelectric composition is produced, particularly, the firing temperature employed in the production of the lead-free piezoelectric composition. For example, as the firing temperature (more specifically, the highest firing temperature) is elevated in firing, the Young's modulus of the lead-free piezoelectric composition can be enhanced.

### B. Piezoelectric element:

### (B-1) Structure of piezoelectric element:

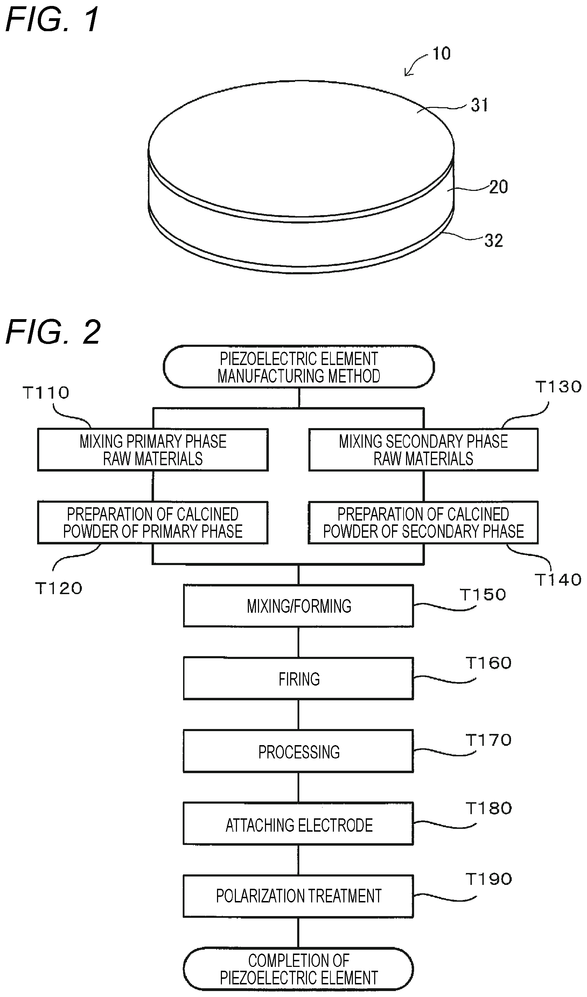

FIG. 1 is a perspective view of an appearance of a piezoelectric element 10 according to the present embodiment. The piezoelectric element 10 has a piezoelectric body 20 formed of the lead-free piezoelectric composition of the present embodiment and electrodes 31 and 32. The piezoelectric element 10 has a configuration in which the electrodes 31 and 32 are attached to the top and bottom surfaces of the disk-shape piezoelectric body 20, respectively. Notably, the piezoelectric element may be formed as a piezoelectric element having different shapes and configurations.

### (B-2) Method of manufacturing piezoelectric element:

FIG. 2 is a flowchart showing an example of a method of manufacturing the piezoelectric element 10. In manufacturing of the piezoelectric element 10, firstly, raw materials of the primary phase of the lead-free piezoelectric composition are mixed (step T110). In this step, powder-form raw materials required for forming the primary phase are selected and weighed so as to achieve a target compositional proportions. The powder-form raw materials may be an oxide, a carbonate salt, or a hydroxide of elements contained in the alkali niobate-based perovskite oxide forming the primary phase. Specific examples of suitable raw materials include K₂CO₃ powder, Na₂CO₃ powder, Li₂CO₃ powder, CaCO₃ powder, SrCO₃ powder, BaCO₃ powder, Nb₂O₅ powder, TiO₂ powder, and ZrO₂ powder. In step T110, ethanol is added to the aforementioned powder raw materials, and the mixture is subjected to wet-mixing by means of a ball mill for, preferably, 15 hours or longer, to thereby prepare a slurry. Then, the slurry is dried to form a mixture powder, which is calcined under conditions, for example, in air at 600 to 1,000°C for 1 to 10 hours, to thereby prepare a powder of calcined materials (hereinafter may also be referred to as "calcined powder) of the primary phase (step T120).

In the above description, mixing of raw materials in step T110 and calcination in step T120 are conducted to prepare a calcined powder. However, another combination may also be employed. For example, a step of mixing raw materials and firing may be repeatedly conducted a plurality of times. More specifically, firstly, powder raw materials including a part of the elements (a plurality of elements) included in a target alkali niobate-based perovskite oxide are mixed and calcined, to thereby yield a calcined powder 1. Then, the thus-obtained calcined powder 1 is mixed with powder raw materials including the remaining elements included in the target alkali niobate-based perovskite oxide, and the resultant mixture is calcined., to thereby yield a calcined powder 2. That is an alternative procedure for preparing a calcined powder of the primary phase.

Separate from the aforementioned step T110, mixing of raw materials of the secondary phase of the lead-free piezoelectric composition is conducted (step T130). In this step, powder-form raw materials required for forming the secondary phase are selected and weighed so as to achieve a target compositional proportions. The powder-form raw materials may be an oxide, a carbonate salt, or a hydroxide of elements contained in the metal oxide such as an oxide having a spinel-type structure or a tungsten bronze-type structure, and forming the secondary phase. More specifically, raw materials are chosen, in accordance with need, from BaCO₃ powder, CO₃ powder, SrCO₃ powder, Na₂CO₃ powder, K₂CO₃ powder, Nb₂O₅ powder, Co₃O₄ power, ZnO powder, TiO₂ powder, etc., and weighed. Then, ethanol is added to the powder raw materials, and the mixture is subjected to wet-mixing by means of a ball mill, to thereby prepare a slurry. Wet-mixing with a ball mill is conducted preferably for 15 hours or longer. Subsequently, the slurry is dried to form a mixture powder, which is calcined under conditions, for example, in air at 600 to 1,300°C for 1 to 10 hours, to thereby prepare a calcined powder of the secondary phase (step T140).

Thereafter, the calcined powder of the primary phase obtained in step T120 and the calcined powder of the secondary phase obtained in step T140 were respectively weighed, and a binder and ethanol are added to the powders. The powder mixture was subjected to wet-mixing by means of a ball mill, to thereby prepare a slurry. The slurry is subjected to drying, granulation, and shaping (step T150). In a specific procedure, the granulated product is monoaxially pressed at a pressure of, for example, 20 MPa, to thereby form a compact having a shape of interest, and the compact is subjected to a CIP treatment (cold isostatic press treatment) at a pressure of, for example, 150 MPa. The CIP body is maintained for firing under conditions, for example, in air at 900 to 1,300°C for 5 hours, to thereby yield a piezoelectric body formed of a lead-free piezoelectric composition (step T160). As described above, the Young's modulus of the lead-free piezoelectric composition can also be regulated by the firing temperature in step T160.

Next, the piezoelectric body obtained in step T160 is cut in accordance with a dimensional precision required for the piezoelectric element 10, and the upper surface and the bottom surface are processed. The dimensions of the piezoelectric element 10 may be appropriately set in accordance with use of the piezoelectric element 10. The thus-obtained piezoelectric body is thermally annealed in air at 100°C for 2 hours so as to stabilize the characteristics thereof (step T170). Annealing treatment may be conducted in air. The annealing temperature is preferably adjusted to, for example, 300°C or higher and 800°C or lower, more preferably 300°C or higher and 600°C or lower. The maintenance time during the annealing treatment is preferably adjusted to 3 hours or longer and 20 hours or shorter, more preferably 5 hours or longer and 10 hours or shorter. Through conducting such an annealing treatment, the structure of the ceramic material including a domain therein is stabilized, whereby the percent change in Qm can be further reduced. Thereafter, electrodes are attached to the surfaces of the piezoelectric body (step T180), and the product is subjected to polarization treatment (step T190), to thereby complete manufacturing of the piezoelectric element 10.

Notably, the aforementioned manufacturing method is merely an example, and many other steps and treatment conditions for manufacturing the piezoelectric element 10 may be employed. For example, instead of separately forming calcined products of the primary phase and the secondary phase, mixing them, and firing, there may be employed an alternative way in which raw materials are mixed at proportions in accordance with the final composition of the lead-free piezoelectric composition, and the mixture is fired. However, when there is employed the method including separately forming calcined products of the primary phase and the secondary phase and mixing them, the compositional ratio of the primary phase to the secondary phase can be more rigorously controlled, whereby the yield of the lead-free piezoelectric composition can be enhanced.

### C. Devices employing piezoelectric element:

The piezoelectric element 10 may be suitably used in the following devices. Examples of such a device include an ultrasonic surgical knife 40, an ultrasonic scaler 50, an ultrasonic cleaning machine 60, an ultrasonic processing machine 70, a piezoelectric transducer 80, an ultrasonic motor 90, a piezoelectric gyro sensor 100, a piezoelectric filter 110, and a knock sensor 120.

### (C-1) Ultrasonic surgical knife

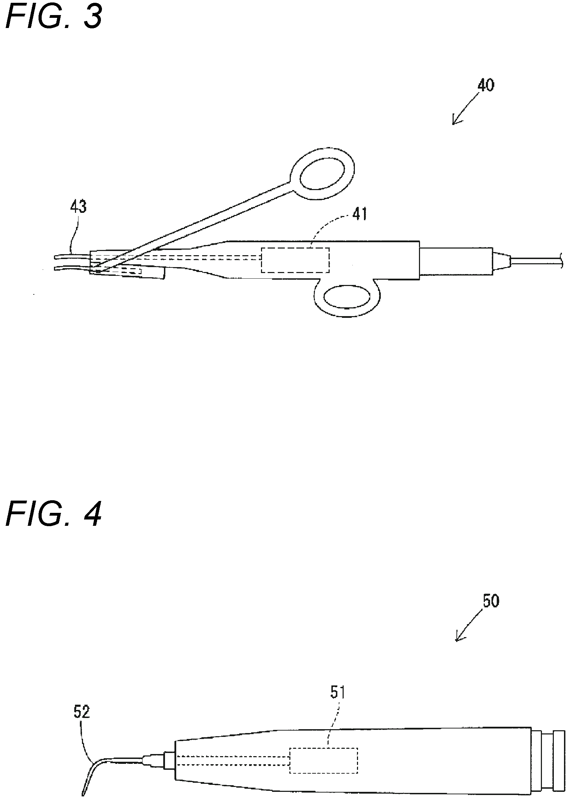

FIG. 3 is a schematic view of an ultrasonic surgical knife 40, which is one embodiment of the present disclosure. The ultrasonic surgical knife 40 has an ultrasonic vibrator 41 and a working member 43. The ultrasonic vibrator 41 has the aforementioned piezoelectric element 10. When an electric signal is applied to the vibrator, the vibrator works to generate ultrasonic vibration. The ultrasonic vibrator 41 is operationally adapted to transfer ultrasonic vibration to the working member 43 in an axial form. The ultrasonic vibrator 41 drives the working member 43 such that a biomedical tissue is cut or peeled, or antibleeding action is provided via thermocoagulation, in the vicinity of the working member 43.

### (C-2) Ultrasonic scaler

FIG. 4 is a schematic view of an ultrasonic scaler 50, which is one embodiment of the present disclosure. The ultrasonic scaler 50 is a dental medical instrument for crushing tartar and stain deposited on teeth by ultrasonic vibration for cleaning. The ultrasonic scaler 50 has an ultrasonic vibrator 51 and a dental chip 52. The ultrasonic vibrator 51 has the aforementioned piezoelectric element 10. When an electric signal is applied to the vibrator, the vibrator works to generate ultrasonic vibration. The ultrasonic vibrator 51 is operationally adapted to transfer ultrasonic vibration to the dental chip 52.

### (C-3) Ultrasonic cleaning machine

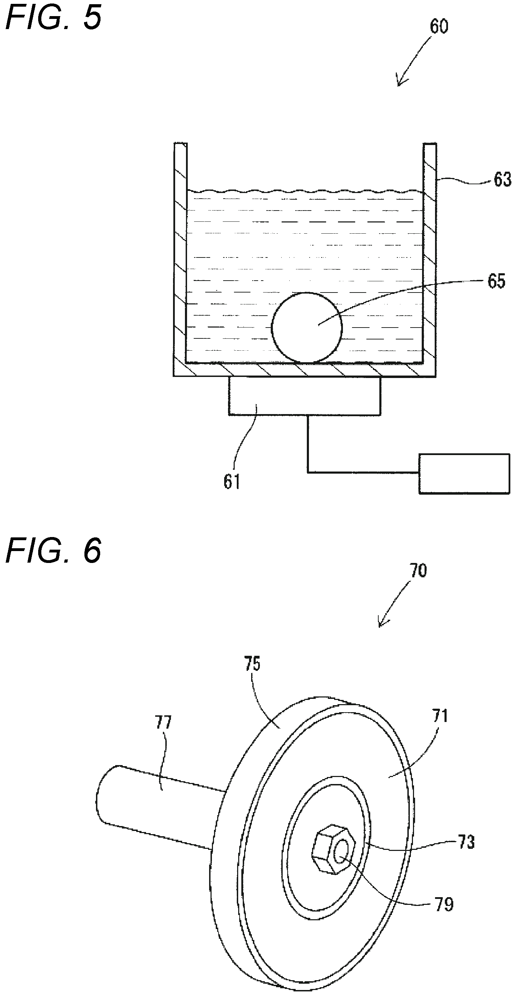

FIG. 5 is a schematic view of an ultrasonic cleaning machine 60, which is one embodiment of the present disclosure. The ultrasonic cleaning machine 60 has an ultrasonic vibrator 61 and a cleaning container 63. The ultrasonic vibrator 61 has the aforementioned piezoelectric element 10. When an electric signal is applied to the vibrator, the vibrator works to generate ultrasonic vibration. When a cleaning object 65 is placed in the cleaning container 63 accommodating a cleaning liquid, and the ultrasonic vibrator 61 generates vibration, the generated ultrasonic vibration is transferred to the cleaning liquid, whereby the cleaning object 65 is cleaned.

### (C-4) Ultrasonic processing machine

FIG. 6 is a schematic view of an ultrasonic processing machine 70, which is one embodiment of the present disclosure. The ultrasonic processing machine 70 has a substrate 71, an ultrasonic vibrator 73, a whetstone part 75, a spindle 77, and a fitting jig 79. The substrate 71 has a disk shape, and a whetstone part 75 is disposed around the circumference of the substrate 71. The center of the substrate 71 is fixed to the spindle 77.

The ultrasonic vibrator 73 has the aforementioned piezoelectric element 10. When an electric signal is applied to the vibrator, the vibrator works to generate ultrasonic vibration. The driving direction of the ultrasonic vibrator 73 corresponds to a radial direction from the center of the substrate 71 to the circumference. While the ultrasonic vibrator 73 generates vibration, the spindle 77 is rotated about the axis line thereof. In this state, when the a whetstone part 75 disposed around the circumference of the substrate 71 is caused to abut a processing target, the target can be cut.

### (C-5) Piezoelectric transducer

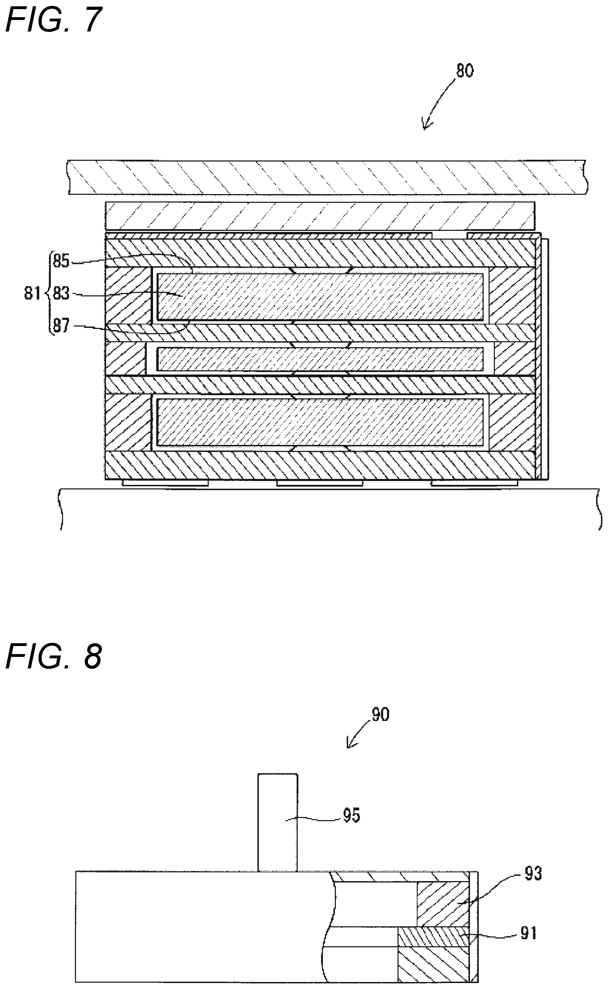

FIG. 7 is a schematic view of a piezoelectric transducer 80, which is one embodiment of the present disclosure. The piezoelectric transducer 80 is an electromechanical energy conversion device that can convert an electric signal to mechanical displacement. The piezoelectric transducer 80 has a piezoelectric element 81. The piezoelectric element 81 has the same configuration as that of the aforementioned piezoelectric element 10. The piezoelectric element 81 has a lead-free piezoelectric member 83, and electrodes 85 and 87 attached to respective surfaces of the lead-free piezoelectric member 83.

### (C-6) Ultrasonic motor

FIG. 8 is a schematic view of an ultrasonic motor 90, which is one embodiment of the present disclosure. The ultrasonic motor 90 has an ultrasonic vibrator 91, a rotor 93, and an output axis 95. The ultrasonic vibrator 91 has the aforementioned piezoelectric element 10. The ultrasonic motor 90 is an actuator that can convert an intrinsic vibration generated by the ultrasonic vibrator 91 to a rotational motion or the like of the rotor 93 via frictional force. For example, when an AC voltage is applied to the piezoelectric element 10, a flexural travelling wave is generated at the ultrasonic vibrator 91, and points on the sliding surface of the ultrasonic vibrator 91 are involved in elliptic motion. When the rotor 93 is pressed onto the sliding surface of the ultrasonic vibrator 91, the rotor 93 receives friction force from the ultrasonic vibrator 91 and rotates in a direction opposite to the direction of the flexural travelling wave.

### (C-7) Piezoelectric gyro sensor

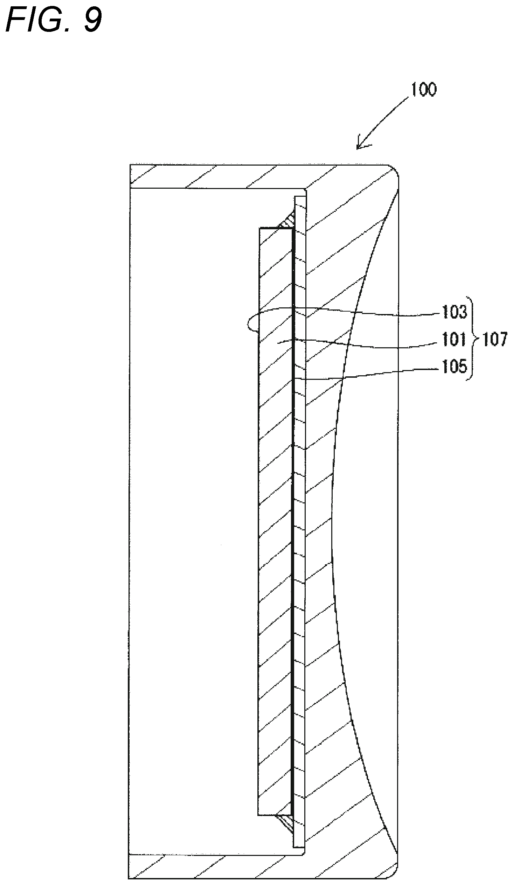

FIG. 9 is a schematic view of a piezoelectric gyro sensor 100, which is one embodiment of the present disclosure. The piezoelectric gyro sensor 100 is a device that can detect an angular velocity through Coriolis force generated at a vibrator. The piezoelectric gyro sensor 100 has a lead-free piezoelectric member 101, and a piezoelectric element 107 having electrodes 103 and 105 applied onto respective surfaces of the lead-free piezoelectric member 101. The piezoelectric element 107 has the same configuration as that of the aforementioned piezoelectric element 10.

### (C-8) Piezoelectric filter

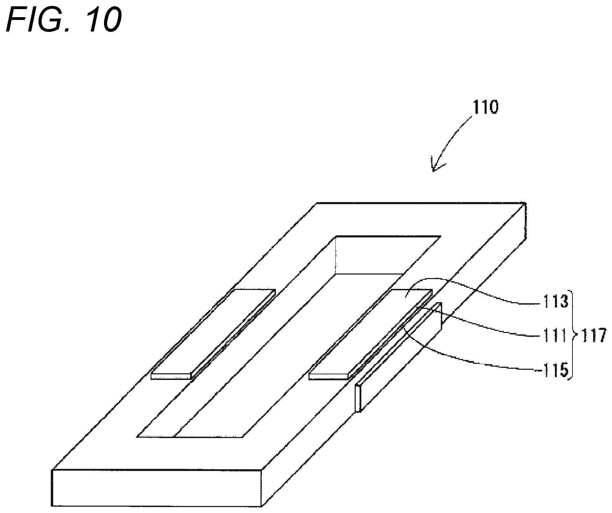

FIG. 10 is a schematic view of a stacked type piezoelectric filter 110, which is one embodiment of the present disclosure. The piezoelectric filter 110 is a device that can receive an electric signal within a specific frequency range by exciting an elastic wave. The stacked type piezoelectric filter 110 has a columnar lead-free piezoelectric member 111, and a piezoelectric element 117 equipped with electrodes 113 and 115 disposed on respective surfaces of the lead-free piezoelectric member 111. The piezoelectric element 117 has the same configuration as that of the aforementioned piezoelectric element 10.

### (C-9) Knock sensor

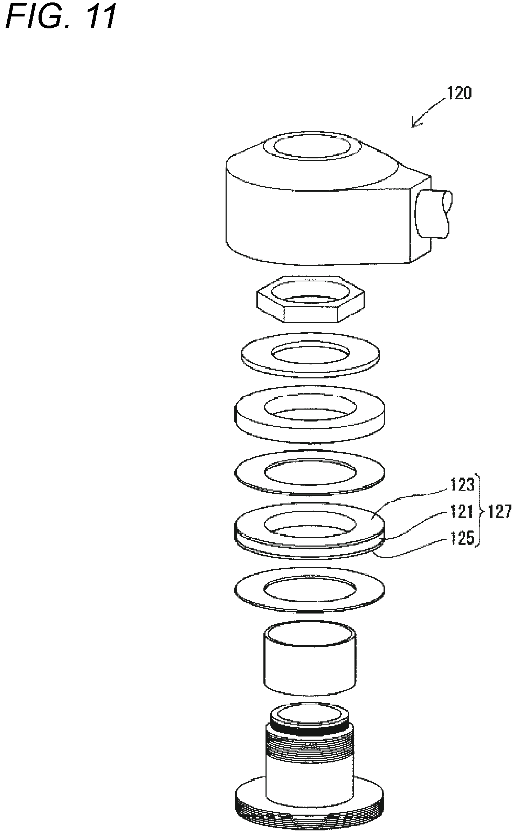

FIG. 11 is a schematic view of a knock sensor 120, which is one embodiment of the present disclosure. The knock sensor 120 is a device that is attached to, for example, an engine block and can detect knocking by converting, to an electric signal, force attributed to vibration of the engine block caused by knocking. The knock sensor 120 has a lead-free piezoelectric member 121, and a piezoelectric element 127 equipped with electrodes 123 and 125. The piezoelectric element 127 has the same configuration as that of the aforementioned piezoelectric element 10.

According to the lead-free piezoelectric composition of the present embodiment manufactured in the aforementioned manner, the lead-free piezoelectric composition includes a primary phase formed of the alkali niobate-based perovskite-type oxide and a secondary phase containing a metal oxide differing from the alkali niobate-based perovskite oxide forming the primary phase, and has a Young' modulus of 90 GPa or higher. Thus, the percent change in mechanical quality factor Qm within a range of low load to high load (i.e., low vibration stress to high vibration stress) can be suppressed. As a result, piezoelectric characteristics can be stabilized within a range of low load to high load, to thereby successfully produce a piezoelectric element ensuring stable operation with reduced energy loss during operation thereof.

### EXAMPLES

Twelve samples of the lead-free piezoelectric composition; i.e., samples S1 to S12, having different features of the primary phase and the secondary phase were prepared. Percent change in Qm within a range of low load to high load was assessed.

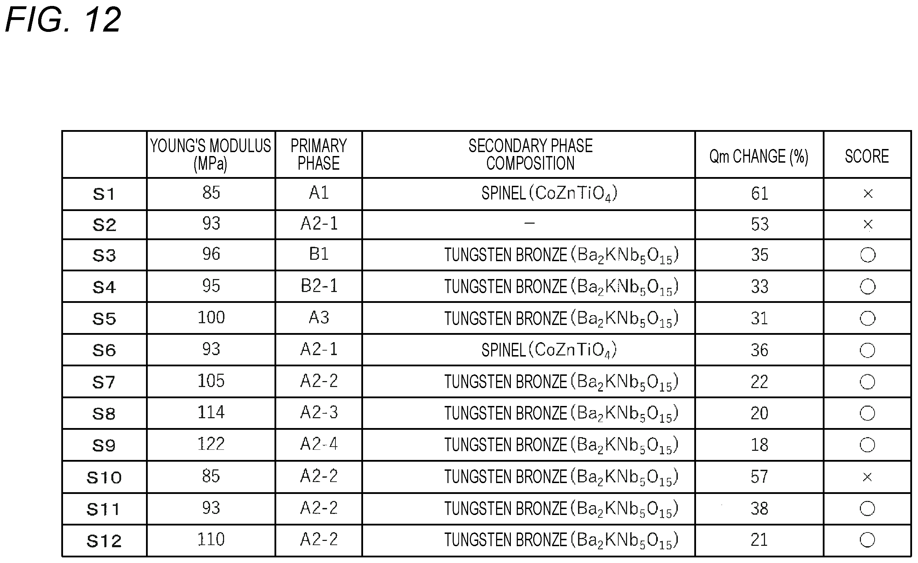

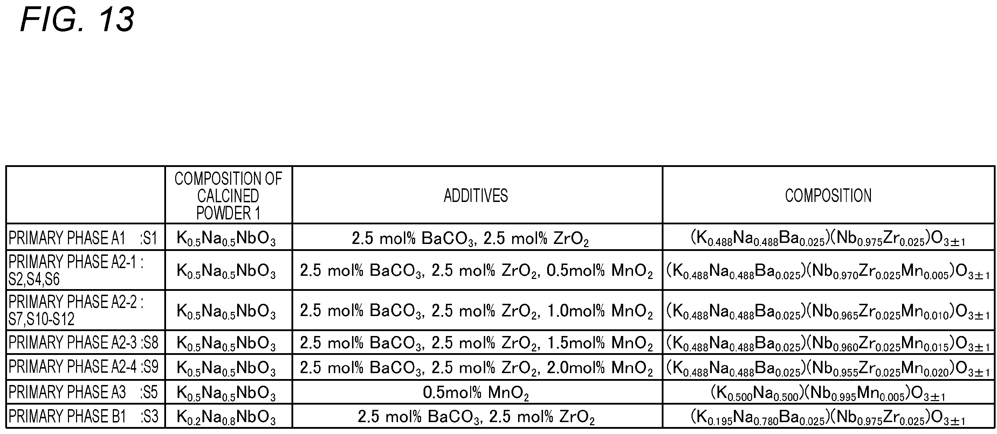

FIG. 12 is a table collectively showing features of samples and results of evaluation. FIG. 13 is a table showing features of the primary phase of each sample. FIG. 13 shows "COMPOSITION OF CALCINED POWDER 1 (prepared for forming a primary phase," "ADDITIVES" added to the calcined powder 1, and the composition of the formed primary phase.

### <Production of lead-free piezoelectric composition>

### [Sample S1]

A lead-free piezoelectric composition including a primary phase represented by "PRIMARY PHASE A1" in FIG. 13 and a secondary phase containing an oxide having a spinel-type structure represented by CoZnTiO₄ was produced as sample S1 (see FIG. 12). In FIG. 2, there are described step T110 including mixing of powder raw materials of the calcined powder for forming the primary phase, and step T120 including calcining the mixed raw materials. In preparation of a calcined powder for forming the primary phase of sample S1 and each of the below-mentioned samples S2 to S12, a part of the powder raw materials of the primary phase was mixed and then calcined, to thereby prepare a calcined powder 1. Subsequently, the remaining of the raw material powders was added to the calcined powder 1 under mixing, and the mixture was calcined, to thereby prepare a calcined powder 2 serving as a calcined powder of the primary phase. In preparation of the calcined powder 1, K₂CO₃ powder, Na₂CO₃ powder, and Nb₂O₅ powder were used as powders of raw material, and weighed in accordance with "COMPOSITION OF CALCINED POWDER 1" shown in FIG. 13. Ethanol was added to the thus-weighed powder raw materials, and the mixture was subjected to wet-mixing by means of a ball mill for 15 hours or longer, to thereby prepare a slurry. Thereafter, the slurry was dried to provide a powder mixture, which was calcined at 900°C in air for 5 hours, to thereby yield the calcined powder 1.

To the thus-obtained calcined powder 1, additives having a composition represented by additives for "PRIMARY PHASE A1" shown in FIG. 13 were added at proportions shown in FIG. 13 (2.5 mol% of BaCO₃ and 2.5 mol% of ZrO₂). The amount of each additive regarding to samples S1 to S12 shown in FIG. 13 refers to a relative amount with respect to the amount of the calcined powder 1 (target of addition) as 100 mol%. Then, ethanol was added to the powder raw materials containing the additives, and the resultant mixture was subjected to wet-mixing by means of a ball mill for 15 hours or longer, to thereby prepare a slurry. Thereafter, the slurry was dried to provide a powder mixture, which was calcined at 900°C in air for 5 hours, to thereby yield the calcined powder 2, serving as the calcined powder of the primary phase.

Separating from the preparation of the calcined powder 2 for forming the aforementioned primary phase, a calcined powder for forming the secondary phase was prepared. In preparation of the calcined powder for forming the secondary phase, Co₃O₄ powder, ZnO powder, and TiO₂ powder were used as powders of raw material, and weighed in accordance with the composition of the secondary phase (CoZnTiO₄) shown in FIG. 12. Ethanol was added to the thus-weighed powder raw materials, and the mixture was subjected to wet-mixing by means of a ball mill for 15 hours or longer, to thereby prepare a slurry. Thereafter, the slurry was dried to provide a powder mixture, which was calcined at 1,200°C in air for 5 hours, to thereby yield a calcined powder for forming the secondary phase (steps T130 to T140).

Thereafter, the aforementioned calcined powder 2 for forming the primary phase and the calcined powder for forming the secondary phase each were weighed. To the thus-weighed powders, ethanol and a binder were added, and the mixture was subjected to wet-mixing by means of a ball mill, to thereby prepare a slurry. Subsequently, the slurry was dried, granulated, and monoaxially pressed at a pressure of 20 MPa, to thereby form a compact of a shape of interest. Then, the compact was subjected to a CIP treatment (cold isostatic pressing) at a pressure of 150 MPa, to thereby yield a subsequent compact (step T150). The thus-obtained compact was fired in air at 1,130°C for 5 hours (step T160), to thereby yield sample S1, which was a lead-free piezoelectric composition (piezoelectric body) including a "primary phase A1" and a secondary phase formed of a spinel-type oxide CoZnTiO₄. Notably, in sample S1 and each of the below-mentioned samples S3 to S12, the secondary phase content (vol%) was adjusted to uniquely 1.5 vol%.

### [Sample S2]

A lead-free piezoelectric composition formed of a primary phase represented by "PRIMARY PHASE A2-1" in FIG. 13 and including no secondary phase was prepared as sample S2. The calcined powder 1 for forming the primary phase of sample S2 was prepared in the same manner as employed for preparing sample S1. To the thus-prepared calcined powder 1, additives with compositional proportions in relation to the additives for "PRIMARY PHASE A2-1" in FIG. 13 were added in proportions shown in FIG. 13 (i.e., 2.5 mol% of BaCO₃, 2.5 mol% of ZrO₂, and 0.5 mol% of MnO₂). Under the same conditions employed in preparing sample S1, the calcined powder 2 was prepared.

Subsequently, ethanol and a binder were added to the calcined powder 2, and the mixture was subjected to wet-mixing by means of a ball mill, to thereby prepare a slurry. Subsequently, the slurry was dried, granulated, and monoaxially pressed at a pressure of 20 MPa, to thereby form a compact of a shape of interest. Then, the compact was subjected to a CIP treatment at a pressure of 150 MPa, to thereby yield a subsequent compact (corresponding to step T150). The thus-obtained compact was fired in air at 1,130°C for 5 hours (corresponding step T160), to thereby yield a lead-free piezoelectric composition (piezoelectric body) of sample S2.

### [Sample S3]

A lead-free piezoelectric composition including a primary phase represented by "PRIMARY PHASE B1" in FIG. 13 and a secondary phase containing an oxide having a tungsten bronze-type structure represented by Ba₂KNb₅O₁₅ was prepared as sample S3 (see FIG. 12). The sample S3 was prepared in the same manner as employed for preparing the calcined powder 1 of sample S1, except that the proportions of K₂CO₃ powder, Na₂CO₃ powder, and Nb₂O₅ powder serving as raw material powders used in preparation of the calcined powder 1 were changed to the values in the column of "COMPOSITION OF CALCINED POWDER 1" shown in FIG. 13. Also, the same conditions for preparing sample S1 were employed in preparation of the calcined powder 2 by adding additives to the calcined powder 1.

In preparation of the calcined powder for forming the secondary phase, BaCO₃ powder, K₂CO₃ powder, and Nb₂O₅ powder were used as raw material powders and weighed in accordance with the composition of the secondary phase (Ba₂KNb₅O₁₅) shown in FIG. 12. To the thus-weighed raw material powders, ethanol was added to the powder raw materials containing the additives, and the resultant mixture was subjected to wet-mixing by means of a ball mill for 15 hours or longer, to thereby prepare a slurry. Thereafter, the slurry was dried to provide a powder mixture, which was calcined at 1,200°C in air for 5 hours, to thereby yield the calcined powder for forming the secondary phase (steps T130 to T140). A lead-free piezoelectric composition (piezoelectric body) was produced from the calcined powder 2 for forming the primary phase and the calcined powder for forming the secondary phase in the same manner as employed for preparing sample S1.

### [Samples S4 to S9]

In preparation of samples S4 to S9, the calcined powder 2 was prepared in the same manner as employed for preparing sample 1, except that the type and amounts of additives added to the calcined powder 1 were changed so as to be provided with the primary phase shown in FIG. 13. Samples S4, S5, and S7 to S9 were prepared by use of the same calcined powder for forming the secondary phase as employed for preparing sample S3. Sample S6 was prepared by use of the same calcined powder as employed for preparing sample S1. A lead-free piezoelectric composition (piezoelectric body) was produced from the calcined powder 2 for forming the primary phase and the calcined powder for forming the secondary phase in the same manner as employed for preparing sample S1.

### [Samples S10 and S11]

Samples S10 and S11 were prepared by use of the same calcined powder 2 for forming the primary phase and calcined powder for forming the secondary phase as employed in preparing sample S7, so as to attain the same composition. However, the firing temperature in step T160 was modified. The firing temperature was altered to 1,130°C (sample S7), 1,100°C (sample S10), 1,120°C (sample S11), and 1,140°C (sample S12). The conditions other than the firing temperature employed in samples S10 to S11 were the same as employed for preparing sample S7.

### <Method of measuring Young's modulus>

The Young's modulus of each sample was measured through "Testing methods for elastic modulus of fine ceramics" based on an ultrasonic pulse method as stipulated in JIS R 1602. Specifically, dynamic elastic modulus was measured on the basis of the propagation speed of an ultrasonic pulse through a test sample. More specifically, a pulse propagation speed was measured with respect to a mirror-polished sample, and the propagation speed was converted to a vertical speed V_{I} (unit: m/s) and a horizontal speed V_{S} (unit: m/s) by means of a vertical wave oscillator and a horizontal wave oscillator. The propagation speed was measured by means of an ultrasonic high-precision thickness meter MODEL 25L (product of Nihon Panametrics). Elastic modulus (Young's modulus) was calculated from the corresponding measurements by the following numerical expression (7). In the numerical expression (7), ρ represents a density of a sample (unit: kg/m³). The density was measured through the Archimedes method. The density herein represents a bulk density, which was derived from the mass of the sample measured in air and that measured in liquid.

### [NE1]

$E = {{V}^{2}}_{s} ρ \frac{3 {{V}^{2}}_{1} - 4 {{V}^{2}}_{s}}{{{V}^{2}}_{1} - {{V}^{2}}_{s}}$ (7)

### <Method of assessing lead-free piezoelectric composition>

Each sample of the lead-free piezoelectric composition was assessed on the basis of the percent change in mechanical quality factor Qm. The mechanical quality factor Qm at each load was measured through an electrical transient response method. The electrical transient response method is a widely known method for calculating piezoelectric characteristics in a high vibration state from an attenuation wave form immediately after application of a pulse voltage. In the present Example, samples each having a 31 shape (i.e., rectangular, 1 mm × 3 mm × 12 mm) were used. By means of a device configuration including a function generator (33500B), a bipolar amplifier (HAS 4052), a laser Doppler vibrator (NLV-2500), and an oscilloscope (DLM3034), a burst wave (100 V) having a oscillation wavelength corresponding to each sample present within a range of 100 kHz to 300 kHz was applied. Immediately after application of the voltage, an attenuation wave form of vibration speed and current was obtained. From the obtained data, mechanical quality factor Qm and vibration stress Tm were calculated by the following numerical expressions (8) to (10).

### [NE2]

${Q}_{m} = \frac{{πf}_{r}}{β}$ (8)

### [NE3]

${s}_{11}^{E} = \frac{1}{4 {ρX}^{2} {f}_{r}^{2}}$ (9)

### [NE4]

${T}_{m} = V \sqrt{\frac{ρ}{{s}_{11}^{E}}}$ (10)

In the numerical expressions, f_{_r} represents an instantaneous frequency of vibration speed; V represents an instantaneous amplitude of vibration speed; β represents an attenuation factor; Qm represents a mechanical quality factor; s₁₁^{E} represents an elastic compliance; ρ represents a density of the sample; X represents a length of the sample; and Tm represents an amplitude (load) of the maximum stress at an equivalent center of the sample. A Tm of 1 MPa was defined as a low load, and a Tm of 20 MPa was defined as a high load. By use of a value of Qm at a Tm of 1 MPa and that at a Tm of 20 MPa, a percent change in Qm was calculated. The "percent change in Qm" was defined as a ratio of the "difference between Qm at a Tm of 1 MPa and Qm at a Tm of 20 MPa" with respect to "Qm at a Tm of 1 MPa" (unit %). In FIG. 12, the case in which the percent change in mechanical quality factor Qm was 40% or lower (i.e., good product) is represented by "O," and the case in which the percent change in Qm was higher than 40% is represented by "X."

As shown in FIG. 12, the percent change in mechanical quality factor Qm within a range of low load to high load (i.e., low vibration stress to high vibration stress) was found to be suppressed by controlling the Young's modulus of the lead-free piezoelectric composition to be 90 GPa or higher (40% or less in Example). The Young's modulus of the lead-free piezoelectric composition may also be adjusted on the basis of, for example, the composition of the primary phase or the secondary phase (see samples S1, and S3 to S9), or on the basis of production conditions such as firing temperature employed in production (see samples S7, and S10 to S12). Thus, when the Young's modulus was regulated to 90 GPa or higher, the percent change in Qm was found to be successfully suppressed.

The present disclosure should not be limited to the aforementioned embodiments and the like and may be carried out in various features, so long as they do not deviate from the gist thereof. For example, technical features residing in the embodiments which features correspond to those residing in the aspects described in the column of SUMMARY OF INVENTION may be appropriately changed or combined, so as to partially or totally solve the aforementioned problems, or partially or totally accomplish the aforementioned effects. Unless the technical features are described as essential elements in the present specification, they may be appropriately discarded.

The present disclosure may be carried out as the following embodiments.

### [Application Example 1]

A lead-free piezoelectric composition characterized by including
a primary phase formed of an alkali niobate-based perovskite-type oxide, and
a secondary phase containing a metal oxide which differs from the alkali niobate-based perovskite-type oxide forming the primary phase,
which composition has a Young's modulus of 90 GPa or higher.

### [Application Example 2]

The lead-free piezoelectric composition according to Application Example 1,
characterized in that the Young's modulus is 100 GPa or higher.

### [Application Example 3]

The lead-free piezoelectric composition according to Application Example 1 or 2,
characterized in that the Young's modulus is 105 GPa or higher.

### [Application Example 4]

The lead-free piezoelectric composition according to any one of Application Examples 1 to 3,
characterized in that the metal oxide forming the secondary phase contains at least one of a metal oxide having a spinel-type structure and a metal oxide having a tungsten bronze-type structure.

### [Application Example 5]

The lead-free piezoelectric composition according to any one of Application Examples 1 to 4,
characterized in that the alkali niobate-based perovskite-type oxide forming the primary phase is an alkali niobate-based perovskite-type oxide represented by a compositional formula (A1ₐM1_{b})_{c}(Nb_{d1}M2_{d2}M3_{d3})O₃₊ₑ (in which element A1 represents at least one alkali metal; element M1 represents at least one of Ba, Ca, and Sr; element M2 represents at least one of Ti, Zr, Ta, Hf, Sn, Sb, and Si; element M3 represents at least one of Mn, Mg, Al, Sc, Fe, Co, Ni, Zn, Ga, and Y; condition: a+b=1 is satisfied; c satisfies a condition: 0.80<c<1.10; conditions: 0<d1<1 and d1+d2+d3=1 are satisfied; and e is a value showing oxygen deficiency or excess).

### [Application Example 6]

The lead-free piezoelectric composition according to Application Example 5,
characterized in that
the element A1 is at least one of K and Na;
the element M2 is at least one of Ti and Zr;
the element M3 is Mn; and;
the condition 0<a≤1 is satisfied.

### [Application Example 7]

A piezoelectric element characterized by having
a piezoelectric body formed of a lead-free piezoelectric composition as recited in any one of Application Examples 1 to 6, and
an electrode attached to the piezoelectric body.

### [Application Example 8]

A device characterized by having an piezoelectric element as recited in Application Example 7.

### [Application Example 9]

The device according to Application Example 8,
which is any of an ultrasonic surgical knife, an ultrasonic scaler, an ultrasonic cleaning machine, an ultrasonic processing machine, a piezoelectric transducer, an ultrasonic motor, a piezoelectric gyro sensor, a piezoelectric filter, and a knock sensor.

### REFERENCE SIGNS LIST

10 piezoelectric element
20 piezoelectric body
31, 32 electrode
40 ultrasonic surgical knife
41 ultrasonic vibrator
43 working member
50 ultrasonic scaler
51 ultrasonic vibrator
52 dental chip
60 ultrasonic cleaning machine
61 ultrasonic vibrator
63 cleaning container
65 cleaning object
70 ultrasonic processing machine
71 substrate
73 ultrasonic vibrator
75 whetstone part
77 spindle
79 fixing jig
80 piezoelectric transducer
81 piezoelectric element
83 lead-free piezoelectric member
85 electrode
90 ultrasonic motor
91 ultrasonic vibrator
93 rotor
95 output axis
100 piezoelectric gyro sensor
101 lead-free piezoelectric member
103 electrode
107 piezoelectric element
110 piezoelectric filter
111 lead-free piezoelectric member
113 electrode
117 piezoelectric element
120 knock sensor
121 lead-free piezoelectric member
123 electrode
127 piezoelectric element

## Claims

1. A lead-free piezoelectric composition **characterized by** comprising
a primary phase formed of an alkali niobate-based perovskite-type oxide, and
a secondary phase containing a metal oxide which differs from the alkali niobate-based perovskite-type oxide forming the primary phase,
which composition has a Young's modulus of 90 GPa or higher.

2. The lead-free piezoelectric composition according to claim 1, wherein
the Young's modulus is 100 GPa or higher.

3. The lead-free piezoelectric composition according to claim 1 or 2, wherein
the Young's modulus is 105 GPa or higher.

4. The lead-free piezoelectric composition according to any one of claims 1 to 3, wherein
the metal oxide forming the secondary phase contains at least one of a metal oxide having a spinel-type structure and a metal oxide having a tungsten bronze-type structure.

5. The lead-free piezoelectric composition according to any one of claims 1 to 4, wherein
the alkali niobate-based perovskite-type oxide forming the primary phase is an alkali niobate-based perovskite-type oxide represented by a compositional formula (A1ₐM1_{b})_{c}(Nb_{d1}M2_{d2}M3_{d3})O₃₊ₑ (wherein element A1 represents at least one alkali metal; element M1 represents at least one of Ba, Ca, and Sr; element M2 represents at least one of Ti, Zr, Ta, Hf, Sn, Sb, and Si; element M3 represents at least one of Mn, Mg, Al, Sc, Fe, Co, Ni, Zn, Ga, and Y; condition: a+b=1 is satisfied; c satisfies a condition: 0.80<c<1.10; conditions: 0<d1<1 and d1+d2+d3=1 are satisfied; and e is a value showing oxygen deficiency or excess).

6. The lead-free piezoelectric composition according to claim 5, wherein
the element A1 is at least one of K and Na;
the element M2 is at least one of Ti and Zr;
the element M3 is Mn; and;
the condition 0<a≤1 is satisfied.

7. A piezoelectric element **characterized by** comprising
a piezoelectric body formed of a lead-free piezoelectric composition as recited in any one of claims 1 to 6, and
an electrode attached to the piezoelectric body.

8. A device **characterized by** comprising a piezoelectric element as recited in claim 7.

9. The device according to claim 8,
which is any of an ultrasonic surgical knife, an ultrasonic scaler, an ultrasonic cleaning machine, an ultrasonic processing machine, a piezoelectric transducer, an ultrasonic motor, a piezoelectric gyro sensor, a piezoelectric filter, and a knock sensor.
